# EUROPÄISCHE PATENTANMELDUNG

(11) **EP 1 589 345 A1**
(43) Veröffentlichungstag der Anmeldung: **26.10.2005**
(21) Anmeldenummer: 04012402.6
(22) Anmeldetag: 26.05.2004
(51) Int. Cl.: G01R 31/08, H02H 1/00, H02H 3/17, H02H 5/10

(54) **Verfahren und Einrichtung zur Isolationsfehlerortung in einem isolierten ungeerdeten Wechselstromnetz**

(30) Priorität: 19.04.2004 DE 102004018918
(71) Anmelder: EAN Elektroschaltanlagen Grimma GmbH, 04668 Grimma (DE)
(72) Erfinder: Steuernagel, Thomas, Dipl.-Ing., 04683 Naunhof (DE); Rathsmann, Stephan,Dipl.-Ing., 04317 Leipzig (DE)
(74) Vertreter: Köhler, Tobias

(57) **Zusammenfassung**

Die Erfindung betrifft ein Verfahren und eine Einrichtung zur Ortung von Isolationsfehlern in einem ungeerdeten elektrischen Wechselspannungsnetz mit Isolationsüberwachungsgerät, so dass bei einem auftretenden Isolationsfehler über einen dann aktivierten Prüfspannungsgenerator ein Prüfstrom zwischen Netz und Erde erzeugt wird.

Vor Auftreten eines Isolationsfehlers werden die Netzstörungen über busfähige Differenzstromwandler mit Meßverstärker und Mikrorechner pro Netzabgang erfasst und über die zugehörige Stromzeitfläche unter Beachtung des maximal zulässigen Prüfstromes wird eine minimale Prüfimpulszeit ermittelt und verwertet und so die Unterscheidung bezüglich Geräte- oder Leitungsfehler ermöglicht.

## Beschreibung

Die Erfindung betrifft ein Verfahren und eine Einrichtung zur Ortung von Isolationsfehlern in einem ungeerdeten elektrischen Wechselspannungsnetz, wobei in diesen zur Isolationsüberwachung des gesamten Netzes ein Isolationsüberwachungsgerät angeordnet ist, dass bei einem auftretenden Isolationsfehler über einen dann aktivierten Prüfspannungsgenerator ein Prüfstrom zwischen Netz und Erde erzeugt wird. Durch Anordnung von Differenzstromwandlern in jeden Netzabgang wird der durch die netzeigene Prüfspannung erzeugte Prüfstrom pro Abgang erfasst und so ausgewertet, dass bei Überschreitung eines parametrierbaren Grenzwertes der fehlerhafte Netzabgang über eine Meldung bzw. Anzeigeeinheit lokalisiert wird.

In geerdeten Netzen werden zur Ortung von Isolationsfehlern die Unsymmetriespannung und/oder der Summenstrom als Kriterium genutzt.

Aus der WO 02/15355 ist ein Verfahren und eine Vorrichtung zur selektiven Erkennung und Ortung von hochohmigen einpoligen Erdfehlern bekannt, bei der ein netzfrequentes Hilfssignal über den Löschkreis eingespeist wird und dadurch die Sternpunkt-Verlagerungsspannung kompensiert wird und Erdfehler bei kompensierter Sternpunkt-Verlagerungsspannung erkannt werden.

Aus der WO 2004/003578 A1 ist ein Verfahren zur Ortung von hochohmigen Erdfehlern bekannt, wobei die Erdadmittanz bzw. Nulladmittanz eines Leitungsabschnittes bzw. - abzweiges durch Einspeisen eines Hilfsignales in den Netzsternpunkt bzw. Nullsystem mit einer Frequenz ungleich der Netzfrequenz ermittelt und zur Erkennung von Erdfehlern herangezogen wird.

In isolierten Netzen erfolgt in analoger Weise die Ortung von Erdschlüssen durch Anordnung von Überstromrelais in den Summenstromkreisen über den kapazitiven Erdschlussstrom über der Erdschlussstelle.

Derartige Verfahren und Vorrichtungen basieren auf der Ermittlung von Verlagerungsspannung, Erdschluss- bzw. Summenstrom und dem Einschwingstrom und sind nicht zur Erkennung und Lokalisierung von Isolationsfehlern in isolierten Netzen einsetzbar.

Es ist weiterhin bekannt, dass in isolierten elektrischen Netzen (IT - Netze) wie z. B. in Krankenhäusern Isolationsüberwachungsgeräte zur Überwachung des Isolationswiderstandes des gesamten Netzes angeordnet werden. Bei Unterschreitung eines minimalen Wertes des Isolationswiderstandes des gesamten Netzes wird ein Warnsignal als Meldung erzeugt. Um den fehlerhaften Abgang schnell zu lokalisieren ist bekannt, bei Ansprechen des Isolationsüberwachungsgerätes auf Grund von Isolationsfehlern einen geringen Prüfstrom fließen zu lassen und über Anordnung von empfindlichen Differenzstromwandlern in jeden Netzabgang eine Fehlerortung durchzuführen. Dabei schaltet das Isolationsüberwachungsgerät entweder netzabhängige und netzunabhängige Prüfspannungsgeneratoren ein, die im isolierten Netz einen sehr geringen und damit ungefährlichen Prüfstrom über den Isolationswiderstand und dir Netzersatzkapazitäten zwischen Netz und Erde fließen lassen.

Zur Gewährleistung des Personenschutzes sind im isolierten Netz nur geringste Prüfströme bis maximal 1 mA zwischen Netz und Erde möglich, so dass bei diesem Verfahren sehr geringe Prüfströme bei sehr niedriger Frequenz von z. B. 2 Hz in den Differenzstromwandlern erfasst werden müssen. Damit werden durch die Differenzstromwandler nur tiefe Frequenzen erfasst.

Trotz der geringen Prüfstromfrequenz werden Netzstörungen z. B. durch Schaltvorgänge von Transformatoren, Schütze usw. im Netz erzeugt, die als niederfrequente Netzstörung das Messergebnis der Prüfsignale verfälschen, wodurch dieses Verfahren zur Fehlerortung in IT - Netzen sehr störempfindlich und unzuverlässig ist. Es werden durch Netzstörungen bedingt bei diesem Verfahren und Einrichtungen oft fehlerhafte Netzabgänge lokalisiert.

Der vorliegenden Einrichtung liegt die Aufgabe zugrunde, ein Verfahren und eine Einrichtung der im Oberbegriff genannten Art zu schaffen, bei dem Netzstörungen in IT - Netzen erkannt und durch entsprechende Maßnahmen vor Auftreten von Isolationsfehlern bei der Fehlerortung eliminiert werden und eine schnelle und fehlerfreie Lokalisierung fehlerhafter Netzabgänge von IT - Netzen erfolgen kann.

Die Lösung der Aufgabe erfolgt dadurch, dass vor Auftreten eines Isolationsfehlers die Netzstörungen über busfähige Differenzstromwandler mit Messverstärker und Mikrorechner pro Netzabgang erfasst werden, über die zugehörige Stromzeitfläche unter Beachtung des maximal zulässigen Prüfstromes eine minimale Prüfimpulszeit ermittelt wird, die zusammen mit einer entsprechend variablen Pausenzeit als optimale Vorgabewerte an einen Prüfspannungsgenerator übermittelt werden, so dass bei Auftreten eines Isolationsfehlers Prüfimpulse zwischen Netz und Erde mit einer optimalen Prüfimpulszeit und Pausenzeit gebildet werden, die gleich oder größer sind als die erfassten Netzstörungen und damit schnellere Fehlerortung ermöglicht und fehlerhafte Messungen vermeidet. Durch zyklische Abfrage bei Ausbleiben von Netzstörungen wird die Prüfimpulszeit und Pausenzeit kontinuierlich bis auf einen Minimalwert von ca. 2 Sekunden verringert. Außerdem wird durch Auswahl der Prüfspannungsform und Prüfspannungsfolge eine Zuordnung des Isolationsfehlerortes pro Leitung bzw. bei vorhandenen elektronischen Geräten die Unterscheidung bezüglich Geräte- oder Leitungsfehler ermöglicht.

Eine geeignete Vorrichtung zur Umsetzung des Verfahrens wird durch einen Prüfspannungsgenerator mit Mikrorechner, Strombegrenzung und einzeln schaltbaren Gleichrichterdioden einer Brückenschaltung zur Prüfsignalerzeugung gebildet. Der Mikrorechner übernimmt alle Funktionen der Steuerung des Prüfspannungsgenerators.

Außerdem sind Differenzstromwandler in jeden Netzabgang angeordnet, die mit Messverstärker, Analog Digital Wandler, Mirkorechner und schaltbarer Rückkopplung im Messkreis zur Kompensation des ohmschen Widerstandes des Differenzstromwandlers während der Prüfimpulszeit und zur Nullstellung des Messstromes in der Pausenzeit ein Messsignal über eine große Prüfimpulszeit bis zu 20 Sekunden und Datenbusverbindung mit allen Geräten erreicht.

Nachfolgend ist das erfindungsgemäße Verfahren beispielhaft beschrieben:

Zur Lösung der gestellten Aufgabe eignet sich ein Verfahren der im Oberbegriff von Anspruch 1 genannten Art dadurch, dass bei Auftreten eines Isolationsfehlers im Netz ein Prüfimpulswechselstrom zwischen Netz und Erde aus mehreren netzsynchronen Einzelimpulsen unmittelbar aus der Netzspannung variabler Zykluszeit erzeugt wird und die Prüfimpulszeit vor Auftreten eines Isolationsfehlers in Abhängigkeit von den aufgetretenen elektrischen Störungen pro Netzabgang ermittelt und die Stromzeitfläche aus Prüfstrom und Prüfimpulszeit gleich oder größer als die Stromzeitfläche der letzten Netzstörungen ist.
Dazu werden die elektrischen Störungen pro Netzabgang laufend erfasst und die Stromzeitflächefläche von Netzstörungen pro Netzabgang ermittelt und unter Berücksichtigung des maximal möglichen Prüfstromes von z. B. 1 mA in IT - Netzen für Krankenhäuser und Prüfimpulszeit berechnet, so dass damit die Prüfimpulszeit immer größer ist als die in einer bestimmten Zeit aufgetretenen Stromzeitfläche der Netzstörungen. Bei Ausbleiben von weiteren Netzstörungen erfolgt eine schrittweise Verringerung der Prüfimpulszeit bis minimal ca. 2 Sekunden,
dass aus Prüfimpulswechselströmen über Differenzstromwandler Messströme pro Netzabgang mit einer Prüfimpulszeit bis ca. 20 Sekunden gebildet werden,
dass vor Auftreten eines Isolationsfehlers die Netzstörungen pro Netzabgang durch vektorielle Erfassung der jeweiligen Betriebsströme der Betriebsleiter erfasst werden,
dass die Prüfspannungsform und Prüfimpulszeit verschieden und variabel ist und dadurch zusätzlich eine Aussage über den gestörten Leiter erfolgen kann,
dass bei Auftreten eines Isolationsfehlers für jeden Netzabgang der Prüfstrom zeitgleich erfasst wird und aus mindestens zwei Messwerten durch Vergleich auch Netzstörungen während der Zykluszeit erkannt werden,
dass bei Auftreten eines Isolationsfehlers eine Lokalisierung des fehlerhaften Abganges durch zeitgleiche Erfassung aller Netzabgänge unmittelbar erfolgt.

Eine automatische Anpassung der Prüfimpulszeit und damit der Messzeit an die vorhandenen Störverhältnisse wird wie nachstehend realisiert:

Kurzzeitig auftretende magnetische Gleichfelder, wie sie von Einschaltströmen induktiver Lasten verursacht werden, können die Messung mit dem empfindlichen Differenzstromwandlern verfälschen. Durch Wahl einer gegenüber den Störimpulsen langen Messzeit, kann das Auswertegerät die Verfälschung durch Mittelwertbildung gering halten. Durch ständige Überwachung seiner Messwerte während des normalen Netzbetriebes (ohne Isolationsfehler) passt das System seine Messzeit an die jeweiligen Störverhältnisse an. Im Fall eines Isolationsfehlers dauert die Suche nur so lang wie nötig.

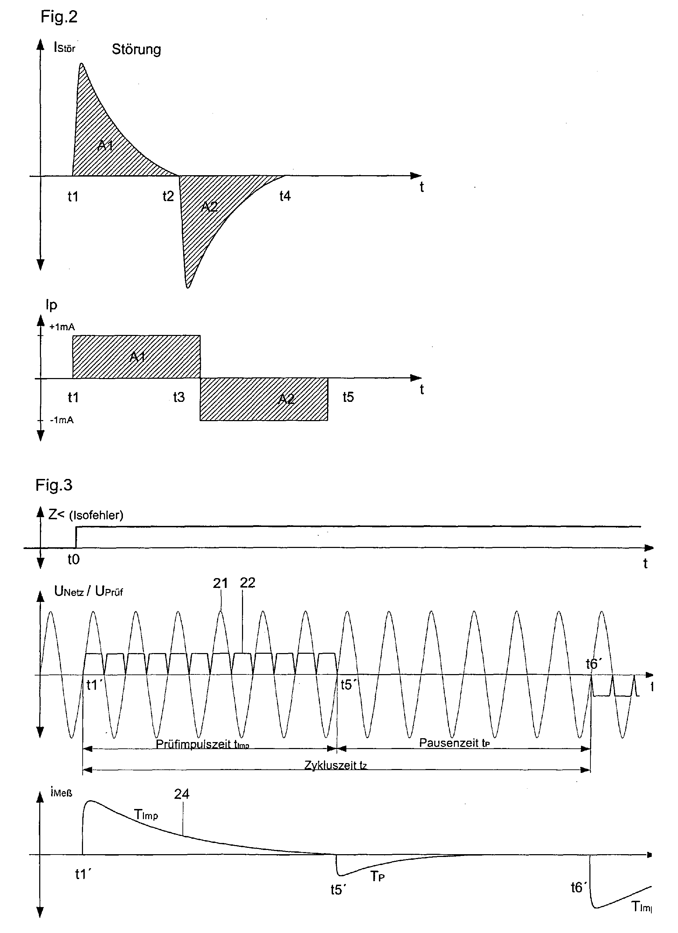

Während der Messzeit wird die negative Zeitkonstante des Messsignals durch Simulation eines negativen Widerstandes über Rückkopplung im Messkreis bestimmt und bei Beginn der Pausenzeit erfolgt eine Nullpunktstellung des Messsignals über Rückkopplung im Messkreis.
Zur Vermeidung von Störungen sind Messzeiten bis ca. 20 Sekunden erforderlich. Durch Anordnung einer veränderlichen Rückkopplung zwischen Messverstärker und Messstromkreis des Differenzstromwandlers wird der Abfall des Messsignals bis ca. 20 Sekunden verzögert.
Während der Messzeit realisiert die Rückkopplung einen negativen Widerstand im Messkreis und damit eine Vergrößerung der Messzeitkonstante Tᵢₘₚ (Fig. 3).
In den Messpausen wird zwischen Messverstärker und Messkreis die Rückkopplung als PI - Regler geschaltet, wodurch das Messsignal zwangsweise auf Null gestellt T_{P} (Fig. 3) wird und damit die Messbereitschaft für den nächsten Prüfimpuls hergestellt wird.

Die Prüfspannungsimpulse können positiv oder negativ sein, eine vorhandene Differenz der beiden zugehörigen Messwerte kennzeichnet genau die fehlerhafte Leitung.

Ein solches Verfahren ist vorteilhaft in Verbindung mit einem Isolationsüberwachungsgerät als Isolationsfehlersuchsystem in verzweigten ungeerdeten Wechselstromnetzen wie zum Beispiel für Krankenhäuser einsetzbar und erlaubt eine zuverlässige, schnelle und störungsunanfällige Ortung und Überwachung fehlerhafter Netzabgänge.

Eine geeignete Einrichtung zur Realisierung des beschriebenen Verfahrens ist, dass bei vorhandenen Isolationsfehlern über einen netzgebundenen Prüfspannungsgenerator ungeglättete und netzsynchrone pulsierende Ableitströme zwischen den Leitern erzeugt werden, die über Strombegrenzung auf eine ungefährliche Größe von ca. 1 mA begrenzt werden. Über elektronische Schalter in jeden Gleichrichterzweig des Prüfspannungsgenerators kann eine pulsierende Gleichspannung als Prüfspannung über eine Zweiweg- oder Einweggleichrichtung mit unterschiedlicher Form, Polarität und Frequenz erzeugt werden.

In jeden Netzabgang ist ein Differenzstromwandler angeordnet. Dieser ist mit Differenzstromsensor, Messverstärker, Analog Digital Umsetzer und schaltbarer Rückkopplung mit Digital Analog Umsetzer und Einkopplung zwischen Analog Digital Umsetzer des Messverstärkers und Differenzstromsensor ausgeführt.
Bei Auftreten eines Prüfstromes auf Grund eines Isolationsfehlers und aktiven Prüfspannungsgenerator erfasst der Differenzstromwandler die zeitlichen Prüfstromänderungen und über die Rückkopplung und Einkopplung wird eine negative Spannung in den Messkreis eingekoppelt, so dass dadurch die Zeitkonstante T_{M} des Messstromes i_{Meß} automatisch verlängert wird und dadurch während der gesamten Prüfimpulszeit trotz vorhandenen Prüfstrom in Form eines pulsförmigen Gleichstromes ein Differenzstrom Messwert in Form einer e-Funktion erzeugt wird. Am Ende der Prüfimpulszeit wird der Prüfstrom Null und die schaltbare Rückkopplung als PI-Regler geschaltet, so dass dadurch eine zwangsweise Nullpunktstellung des Messstromes über die Zeitkonstante T_{P} erzwungen wird. Die Messströme in einem Netzabgang werden über Mikrorechner digital erfasst und gespeichert. Durch den Mikrorechner erfolgt während jeder Prüfspannungszeit eine Mittelwertbildung des Messstromes pro Netzabgang. Dieser Mittelwert ist ein Maß für den Isolationsfehler pro Netzabgang. Der Mikrorechner übernimmt alle Steuerungen und Berechnungen. Über vorhandene Busschnittstellen des Mikrorechners können alle erfolgten Auswertungen und Ergebnisse zeitgleich über alle Netzabgänge erfolgen.

Die Erfindung wird anhand der folgenden Ausführungsbeispiele näher erläutert und es zeigen:
Fig. 1 Übersichtsdarstellung einer Einrichtung nach der vorliegenden Erfindung
Fig. 2 Zeitlicher Verlauf und Darstellung Stromzeitfläche einer Netzstörung
Fig. 3 Zeitlicher Verlauf Prüfspannung und Messstrom Fig. 4 Schematische Darstellung Isolationsfehler

Zunächst wird auf das bekannte Verfahren zur Isolationsfehlerortung in isolierten Netzen näher eingegangen.

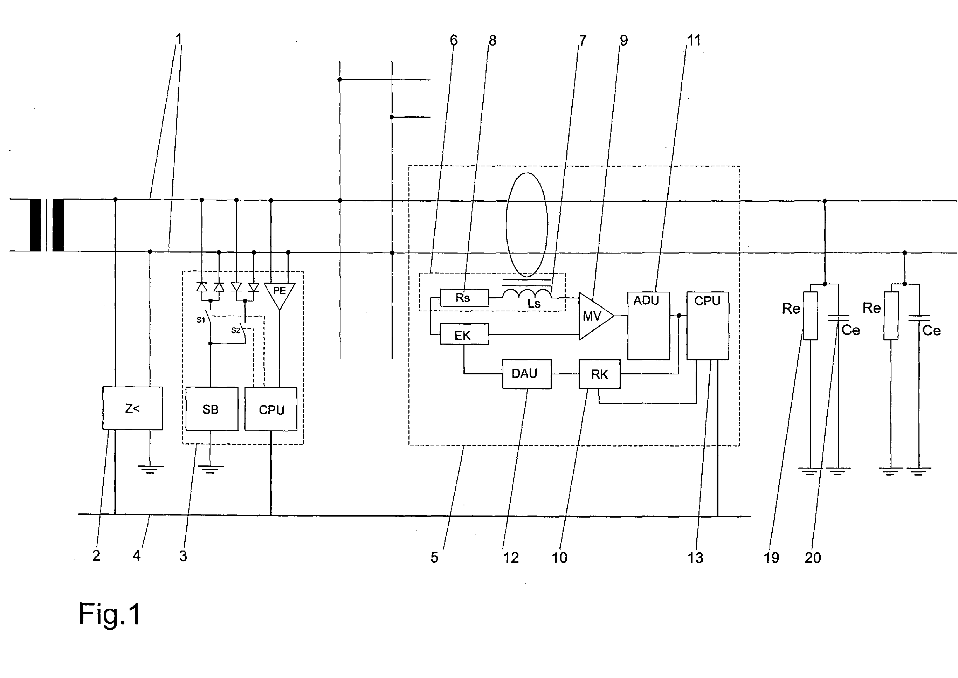

In Fig. 1 ist ein isoliertes Netz bestehend aus den Netzleitern 1 dargestellt. Ein unvermeidbarer Isolationswiderstand mit ohmschen Widerstand Rₑ und kapazitiven Widerständen Cₑ stellt eine Netzabteilung zwischen Netzleitern 1 und Erde dar. Zur Überwachung des ohmschen Anteiles des Isolationswiderstandes ist ein Isolationsüberwachungsgerät 2 zwischen Netzleitern 1 und Erde angeordnet.

Bei Auftreten eines maßgeblichen Isolationsfehlers im Netz erfolgt die Feststellung desselben mit einem Isolationsüberwachungsgerät 2 und es erfolgt eine Meldung über ein nicht dargestelltes Auswertungsgerät.
Außerdem erfolgt eine Aktivierung eines Prüfspannungsgenerators 3 derart, dass dieser dann einen netzgetriebenen Prüfstrom fester Frequenz über die Ableitwiderstände Rₑ erzeugt und dieser für jeden Netzabgang mittels Differenzstromwandler gemessen wird und die einzelnen Differenzstrom Messwerte zeitmultiplex an eine Auswerteeinheit übertragen werden. Nach Auswertung der Messergebnisse aller Netzabgänge kann dadurch eine Isolationsfehlerortung erfolgen.

Der wesentliche Nachteil besteht darin, dass die fest vorhandene Prüfimpulszeit des Prüfspannungsgenerators an die Länge der maximal möglichen Übertragungszeit des induktiven Messverfahrens des Differenzstromwandlers angepasst sind und damit maximale Messzeiten von ca. 2 Sekunden zur Erfassung des Prüfsignals möglich sind. Netzstörungen, die z. B. auf Grund von Schalthandlungen von Transformatoren, Schützen im Netz auftreten, werden in dieser festen Messzeit mit erfasst und führen zu Messfehlern. Wenn nämlich während der Prüfimpulsdauer Netzstörungen auftreten, verfälschen diese das Messergebnis und es treten deutliche Messfehler auf.

Es folgt nunmehr die Beschreibung der Besonderheit der vorliegenden Erfindung.

In Figur 2 ist für den Fall einer beispielhaften Störung zum Zeitpunkt t₁ bis zum Zeitpunkt t₂ der zeitliche Verlauf des Messstromes eines Differenzstromwandlers dargestellt. Zu Beginn jeder Schalthandlung im Netz steigt der Messstrom durch die Störung deutlich an und klingt nach einer e-Funktion bis zum Endwert langsam ab. Der Vorgang wiederholt sich auf Grund der Schalthandlung von t₂ bis t₄ in umgekehrter Polarität. Aus diesen zeitlichen Verlauf wird durch Integration des Messstromes das zugehörige Strom-Zeit-Produkt A1 und A2 über die gesamte Störzeit gebildet und gespeichert. Durch anschließende Division des Strom-Zeit-Produktes der erfassten Störung A1 und A2 durch den zur Gewährleistung des Personenschutzes maximal zulässigen Prüfimpulsstromes z. B. 1 mA ergibt sich die Zeit t₃ bzw. t₅. Diese berechnete Zeit t₃ bzw. t₅ wird als Prüfimpulszeit t₅ bzw. t₆ dem Prüfspannungsgenerator als Vorgabewert übermittelt. Bei einer Veränderung der Netzstörungen wird die Prüfimpulszeit selbsttätig entsprechend angepasst. Wird über eine längere parametierbare Zeit keine Netzstörung erfasst, wird der Prüfimpulszeit des Prüfspannungsgenerators schrittweise bis auf minimal 2 Sekunden verringert.

In Figur 3 tritt ein Isolationsfehler zum Zeitpunkt t₀ auf, der durch ein Isolationsüberwachungsgerät signalisiert wird. Im nächsten Nulldurchgang der Netzspannung zum Zeitpunkt t₁ wird dadurch der Prüfspannungsgenerator mit der voreingestellten Prüfsignalzeit Tᵢₘₚ gestartet. Der Messstrom I_{Meß} steigt sprunghaft an und klingt nach einer e-Funktion ab. Durch die Rückkopplung im Messkreis des Differenzstromwandlers wird in den Messkreis eine negative Spannung eingespeist, so dass dadurch die Zeitkonstante T_{Imp} entsprechend variabel ist und über die gesamte Prüfimpulszeit einen Messstrom I_{Meß} erfasst wird. Nach Ablauf der Prüfimpulszeit zum Zeitpunkt t₅ werden während der Impulspausenzeit t_{P} bis zum Zeitpunkt t₆ die Prüfimpulse abgeschaltet. Dadurch wird zum Zeitpunkt t₅ ein Messstrom mit umgekehrter Polarität erzeugt, der durch Umschalten der Rückkopplung RK in Form eines PI-Reglers zwangsweise und innerhalb kurzer zeit auf Null geschaltet wird. Zum Zeitpunkt t₆ ist ein Messzyklus abgeschlossen und es beginnt eine neuer Messzyklus mit umgekehrter Polarität.

In Fig. 1 ist eine Einrichtung bestehend aus Isolationsüberwachungsgerät 2, Prüfspannungsgenerator 3 und Differenzstromwandler 5 in einem isolierten Netz mit Netzleitern 1 und Isolationswiderstand mit ohmschen Widerstand Rₑ und kapazitiven Widerstand Cₑ dargestellt. Die Geräte sind mittels Busleitung 4 miteinander verbunden. Bereits vor Auftreten eines Isolationsfehlers werden die auftretenden Netzstörungen über die Differenzstromwandler 5 erfasst und entsprechend Fig. 2 die Prüfimpulszeit berechnet und über die Busleitung 4 an den Prüfsignalgenerator 3 übertragen. Über CPU und Schalter s1 und s2 des Prüfspannungsgenerator 3 werden pulsierende Prüfströme variabler Länge und Polarität erzeugt, die über die ohmschen Widerstände Rₑ 19 und den Prüfspannungsgenerator 3 fließen. Die Messung des Prüfstromes für jeden Netzabgang erfolgt durch Differenzstromwandler 5. Zur Erreichung großer Prüfimpulszeiten ist eine schaltbare Rückkopplung RK 10 in dem Messkreis des Differenzstromwandlers 5 angeordnet, die während der Prüfimpulszeit eine negative Spannung über die Rückkopplung RK 10 in den Messkreis einspeist und damit die Zeitkonstante des Messstromes I_{Meß} bis zu ca. 20 Sekunden erhöht. Während der Pausenzeit wird die Rückkopplung RK als PI-Regler geschaltet und dadurch eine Nullstellung des Messstromes I_{Meß} in der Pausenzeit erzwungen.

Es sollen im Folgenden die Funktion des Prüfspannungsgenerators und die Fehlerunterscheidungsmöglichkeiten, die sich daraus ergeben, beschrieben werden.

Um einen Prüfstrom durch den Isolationswiderstand zu treiben, nimmt der Prüfspannungsgenerator eine definierte Erdung des Netzes vor. Diese Erdung geschieht über die in Fig. 1 gezeichnete Strombegrenzung SB. Dieser Zweipol hält den fließenden Prüfstrom unabhängig vom Spannungsabfall über sich selbst konstant. Über ein schaltbares Diodennetzwerk lässt er sich auf unterschiedliche Arten zwischen Netz und Erde schalten, wodurch die Einspeisung unterschiedlicher Prüfspannungsarten in das Netz möglich ist. Je nach Art des vorliegenden Isolationsfehlers kommt es bei den unterschiedlichen Prüfspannungsarten zu Prüfstromflüssen oder nicht. Aus der Auswertung der Prüfstromflüsse bei den verschiedenen Prüfspannungsarten kann auf die Art des Isolationsfehlers geschlossen werden. Es ist dadurch eine Aussage möglich, auf welcher Netzleitung L1, L2 sich ein Isolationsfehler befindet und ob er im Netz selbst oder in einem Gerät hinter einem Netzgleichrichter aufgetreten ist.

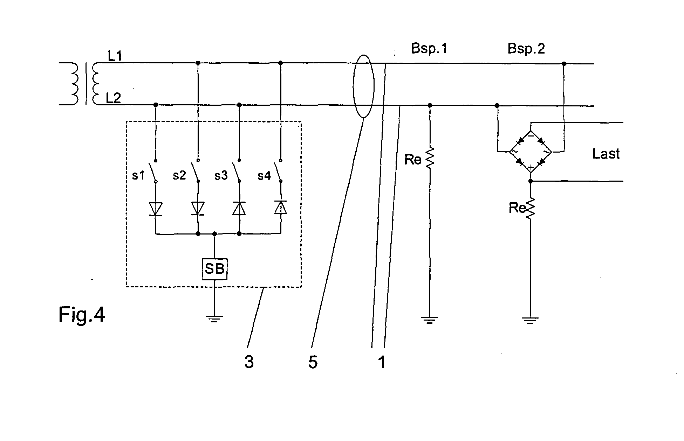

In Fig. 4 ist in einem isolierten Netz ohne Isolationsüberwachungsgerät der Aufbau des Prüfspannungsgenerators zur Erläuterung der Funktion schematisch dargestellt. Daneben sind zwei Beispiele für mögliche Isolationsfehler eingezeichnet.
Im Beispiel 1 führt nur das Schließen der Schalter S4 oder S2 zu einem Stromfluss über den ohmschen Widerstand Rₑ. Bei einem solchen Isolationsfehler auf der Netzleitung L1 wären es entsprechend Schalter S3 oder S1. Beispiel 2 zeigt einen isolationsfehler, gekennzeichnet durch den ohmschen Widerstand Rₑ, hinter einem Netzgleichrichter. Da sich der Isolationsfehler am Pluspol befindet, führt nur das Schließen der Schalter S3 und/oder S4 zu einem Stromfluss. Am Minuspol wären es S1 und/oder S2.

Um den praktischen Aufbau des Prüfspannungsgenerators zu vereinfachen, d. h. Relais zu sparen, lässt sich die Strombegrenzung durch Mirkorechner steuerbar gestalten und diesem würde eine Phasenerkennung zur Bestimmung der aktuellen Netzpolarität gegeben. Dadurch bekommt er die Möglichkeit die Strombegrenzung gezielt nur zu einer der beiden Netzpolaritäten einzuschalten, was zur gleichen Funktion wie in Fig. 4 gezeigten führt.

### Bezugszeichenliste

- 1: Netzleiter
- 2: Isolationsüberwachungsgerät (Z<)
- 3: Prüfspannungsgenerator
- 4: Busleitung
- 5: Differenzstromwandler
- 6: Differenzstromsensor
- 7: Ersatzinduktivität
- 8: Ersatzwiderstand
- 9: Meßverstärker
- 10: Rückkopplung
- 11: Analog Digital Umsetzer
- 12: Digital Analog Umsetzer
- 13: Mikrorechner
- 14: Prüfstrom
- 15: Zykluszeit
- 16: Prüfimpulszeit
- 17: Pausenzeit
- 18: Differenzstrom - Meßwert
- 19: Ohmscher Widerstand
- 20: Kapazitiver Widerstand
- 21: Netzspannung
- 22: Prüfspannung
- 23: Prüfstrom

## Patentansprüche

1. Verfahren zur Ortung von Isolationsfehlern in isolierten ungeerdeten Wechselspannungsnetzen mit Isolationsüberwachungsgerät zur Isolationsüberwachung und netzeigenen Prüfspannungsgenerator, so dass bei Auftreten und Erfassung eines Isolationsfehlers durch das Isolationsüberwachungsgerät durch Schließen des Fehlerstromkreises über Gleichrichter und Strombegrenzung des Prüfspannungsgenerators und über Netzleiter und Erde ein Prüfstrom niedriger Frequenz fließt, der durch Anordnung von Differenzstromwandlern in jeden einzelnen Netzabgang erfasst wird und die Fehlerortung durch Auswertung der Größe des zugehörigen Prüfstromes pro Netzabgang erfolgt **dadurch gekennzeichnet, dass** für jeden Netzabgang im abgeschalteten Zustand des Prüfspannungsgenerators der zeitliche Verlauf von Netzstörungen erfasst wird und über die zugehörige Stromzeitfläche und einem zulässigen Prüfstrom eine minimale Prüfimpulszeit gebildet wird, dass aus dem zeitlichen Verlauf der Netzstörungen die Stromzeitfläche ermittelt und gespeichert wird und eine variable Verknüpfung der Prüfimpulszeit der Prüfspannung mit diesen gefassten Netzstörungen gebildet wird, dass die Prüfspannung aus pulsierenden netzsynchronen Einzelimpulsen mit einer Dauer zwischen 2 Sekunden und 20 Sekunden besteht, dass die Pausenzeit der Prüfimpulszeit entspricht, dass bei Ausbleiben von Netzstörungen die Prüfimpulszeit schrittweise bis auf minimal 2 Sekunden verringert wird.

2. Einrichtung zur Durchführung des Verfahrens nach Anspruch 1 mit einer netzeigenen Prüfspannung, die mit Gleichrichtern und Strombegrenzung ausgeführt ist und die aus dem Prüfstrom über Differenzstromwandler mit Differenzstromsensor den Isolationsfehler pro Abgang erfasst **dadurch gekennzeichnet, dass** die Prüfspannung im Nulldurchgang der Netzspannung schaltbar ist und positiver und/oder negativer Polarität sind,
dass der Differenzstromwandler mit Messverstärker, Analog Digitalumsetzer und Mikrorechner mit Busschnittstelle ausgeführt sind und dass eine schaltbare Rückkopplung im Messstromkreis angeordnet ist, die während der Prüfimpulszeit die Induktivität des Differenzstromwandlers über Spannungseinspeisung kompensiert und während der Pausenzeit über PI-Kopplung den Messstrom auf Null stellt, dass in dem Mikrorechner während der Prüfimpulszeit ein Mittelwert über die gesamt Prüfimpulsdauer gebildet wird und dieser Mittelwert ein Maß für den Isolationsfehler pro Netzabgang ist,
dass Isolationsüberwachungsgerät, Differenzstromwandler und Prüfspannungsgenerator über eine Busleitung verbunden sind.
